(19) Europäisches Patentamt
European Patent Office
Office européen des brevets

(11) **EP 3 836 390 A1**

(12) **EUROPEAN PATENT APPLICATION**

(43) Date of publication:
**16.06.2021 Bulletin 2021/24**

(51) Int Cl.:
*H03B 5/32* *(2006.01)*      *H03K 3/66* *(2006.01)*

(21) Application number: **19216018.2**

(22) Date of filing: **13.12.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **MINISWYS SA**
**2502 Biel (CH)**

(72) Inventors:
• **BRUMANN, Michaël**
**2503 Biel/Bienne (CH)**
• **HOESLI, Raphaël**
**2560 Nidau (CH)**
• **SIGRIST, Martin**
**3005 Bern (CH)**

(74) Representative: **Frei Patent Attorneys**
**Frei Patentanwaltsbüro AG**
**Postfach**
**8032 Zürich (CH)**

Remarks:
Claims 16 - 25 are deemed to be abandoned due to non-payment of the claims fees (Rule 45(3) EPC).

(54) **METHOD FOR OPERATING A DRIVE UNIT AND DRIVE UNIT**

(57)      A method serves for operating a drive unit comprising an active element (1) having a resonator (2) and an excitation means (23) for exciting oscillations in the resonator (2) and thereby driving a passive element (4).

The method comprises the steps of
• driving the excitation means (23) with a **driving signal,** the driving signal being a periodic signal comprising **driving pulses** repeated with an **excitation frequency;**

• depending on a **control signal,** modifying the driving signal by:
◦ if the control signal is within a first range, modifying the excitation frequency or modifying the shape of the driving pulses, and
◦ if the control signal is within a second range, repeatedly omitting driving pulses.

**Fig. 5**

EP 3 836 390 A1

**Description**

The invention relates to the field of miniaturised drives, for example piezoelectric drives. More particularly, it relates to a method for operating a drive unit and a drive unit as described in the preamble of the corresponding independent claims.

Such drives are disclosed, for example, in the applicant's WO 2006/000118 A1 or US 7'429'812 B2, and WO 2019/068708 A1. Such drives comprise one, two or more arms that are made to oscillate, and by an oscillating movement at the end of the arms drive a passive element. The frequency of an excitation means driving the oscillating movement can be chosen so as to generate a mode of oscillation that causes the arms to move the passive element either a first direction or in a second, opposite direction. There is a need for further improvement of such drives, in particular for increasing the range of speeds at which the passive element can be made to move.

It is therefore an object of the invention to create method for operating a drive unit of the type mentioned initially that allows for an larger operating range of the drive unit.

These objects are achieved by a method for operating a drive unit and a drive unit according to the claims.

The method serves for operating a drive unit for driving a passive element relative to an active element, wherein the active element comprises

a resonator and at least one excitation means for exciting oscillations in the resonator,
the resonator comprising at least one arm extending from a connection region of the resonator,
the at least one arm comprising, at an outer end of the arm, a contact element,
the contact element being movable by way of oscillating movements of the at least one arm,

the passive element being arranged to be driven and moved relative to the active element by way of these oscillating movements;
the passive element comprising a first contact area, the first contact area being arranged to be in contact with the first contact element;
the active element and passive element being arranged for a pre-stress force to push, in particular when the active element is not being excited, at least the first contact element towards the first contact area.

The method comprises the steps of

- driving the excitation means with a **driving signal**, the driving signal being a periodic signal comprising **driving pulses** repeated with an **excitation frequency**;
- depending on a **control signal,** modifying the driving signal by:

  ◦ if the control signal is within a first range, modifying the excitation frequency or modifying the shape of the driving pulses while keeping the excitation frequency the same, while keeping an energy transmitted by each driving pulse above a nonzero **minimum pulse energy value,** in particular wherein the minimum pulse energy value is at least 5% of a maximum energy of a pulse; and
  ◦ if the control signal is within a second range, repeatedly omitting driving pulses.

Throughout the present document, whenever the speed and position of the drive unit is referred to, this generally denotes speed or position of a movement of the passive element relative to the active element. The movement can be, depending on the mechanical construction and the manner of excitation, linear or rotational or a combination.

According to an **aspect** of the invention, the step of repeatedly omitting driving pulses if the control signal is within a second range is not performed. That is, one or more of the method steps described in the following are performed without the omitting of driving pulses taking place.

In embodiments, the method is for operating a drive unit for driving a passive element relative to an active element, wherein the active element comprises

a resonator and at least one excitation means for exciting oscillations in the resonator,
the resonator comprising at least two arms extending from a connection region of the resonator,
each of the arms comprising, at an outer end of the arm, a respective contact element,
the contact elements being movable by way of oscillating movements of the respective arm

the passive element being arranged to be driven and moved relative to the active element by way of these oscillating movements;
the passive element comprising a first and a second contact area, each contact area being arranged to be in contact with a respective one of the first and second contact elements,

the active element and passive element being arranged for a pre-stress force to push, in particular when the active element is not being excited, the first and second contact elements towards the respective first and second contact area.

In embodiments, the first and second range overlap.

In embodiments, modifying the shape of the driving pulses is done by at least one of

- modifying the **amplitude** of the driving pulses depending on the control signal; and of
- modifying the **width** of the driving pulses depending on the control signal.

In embodiments, keeping the energy transmitted by each driving pulse above the nonzero **minimum pulse energy value** is accomplished by keeping the pulse duty cycle of the driving pulses above a minimum pulse duty cycle value and by keeping the amplitude of the driving pulses above a minimum amplitude value.

In embodiments, the **minimum pulse energy value** is at least 5% or at least 10% of a maximum energy of a pulse.

In embodiments, modifying the excitation frequency depending on the control signal comprises modifying the excitation frequency by an amount that does not alter the mode of oscillation but only reduces the matching between the excitation frequency and the natural frequency of the drive unit in this mode of oscillation. This reduces an energy transfer into the mechanical oscillation, and consequently its amplitude.

In embodiments, repeatedly omitting driving pulses, comprises modifying a duration of **turn-off periods** of time during which driving pulses are omitted depending on the control signal.

This allows to drive the passive element in a quasi-continuous manner at a comparatively low average speed.

In embodiments, when repeatedly omitting driving pulses, during **turn-off periods** of time during which driving pulses are omitted, the pre-stress force holds the position of the passive element relative to the active element.

In embodiments, when repeatedly omitting driving pulses, a duration of **turn-on periods** of time during which driving pulses are applied is sufficient for the oscillations of the active element to achieve an amplitude at which the active element drives the passive element.

In embodiments, the excitation frequency is in the range between 50 kHz and 1000 kHz, and the repeated omission of driving pulses occurs with a frequency that is 10 to 100 times lower than the excitation frequency.

In embodiments, the control signal corresponds to a speed set point, and the first range corresponds to higher speeds and the second range corresponds to lower speeds.

Consequently the method can comprise, if the control signal represents a speed in a higher range, modifying the excitation frequency or modifying the shape of the driving pulses while keeping the excitation frequency the same, while keeping an energy transmitted by each driving pulse above a nonzero **minimum pulse energy value**; and if the control signal represents a speed in a lower range, repeatedly omitting driving pulses.

This allows to achieve a given speed set point even if it is below a speed that can be achieved by reducing the shape of the driving pulses alone, and which would reduce the energy of the driving pulses below a threshold that is required for the drive to operate reliably.

In embodiments, the control signal corresponds to a position set point, and a position step size by which the position changes in one pulse period is controlled by modifying the shape of the driving pulses or the excitation frequency.

In embodiments, the method comprises, for actively reducing the speed of the drive unit, the steps of

- driving the excitation means with a first **driving signal** having a first excitation frequency driving the drive in a first direction;
- reducing the speed by driving the excitation means with a second **driving signal** having a second excitation frequency driving the drive in a second direction opposite to the first direction.

In embodiments, reducing the speed of the drive is accomplished by reducing the duty cycle and/or the amplitude of the driving pulses while keeping the excitation frequency the same, or by detuning the excitation frequency from the natural frequency of the drive unit while essentially maintaining its mode of oscillation.

In embodiments, reducing the speed of the drive is accomplished by omitting driving pulses and by braking the drive by means of the pre-stress force.

In embodiments, the method comprises, for controlling the movement of the drive unit by switching between at least two excitation frequencies, the repeated execution of the steps of.

- for a first number of pulses, driving the excitation means with a first **driving signal** having a first excitation frequency;
- for a second number of pulses, driving the excitation means with a second **driving signal** having a second excitation frequency.

In embodiments, the first and second number of pulses are lower than a number of pulses required to bring the resonator into a steady state of oscillation. That is, the oscillations generated by the first and second driving signal shift from one transient state (after switching from the first to the second excitation frequency) to another transient state (after switching from the second to the first excitation frequency), and back again. The overall effect is that the direction in which the contact elements push and drive the passive element is modified. It can be controlled by choosing the two excitation frequencies and the first and second number of pulses. Actual values to be used depend on the geometry of the active element and can be determined by simulation and/or experimentation.

This method of switching between two - or more - excitation frequencies can be implemented independently from and without the step of repeatedly omitting drive pulses.

In embodiments, the method comprises the step of determining the excitation frequency depending on a desired oscillation mode of the resonator, in particular depending on a desired direction of relative movement of the passive element relative to the active element, by the steps of

- repeatedly driving the active element with different excitation frequencies and measuring, for each excitation frequency, an associated response of the drive unit, in particular the response being a speed of movement or a displacement of the passive element relative to the active element;
- selecting, for future operation of the drive unit, an optimal excitation frequency that optimises the response, in particular maximises the response.

This allows to adapt the driving frequency, and thereby the efficiency by which energy from the excitation signal is transferred to mechanical energy in the oscillation of the active element.

In embodiments, for each of the different excitation frequencies being evaluated, a certain number of drive pulses is applied to the active element, and the resulting linear or rotational or combined displacement is measured, representing the response.

In embodiments, for each of the different excitation frequencies being evaluated, drive pulses are applied to the active element, and the steady state speed (linear or rotational or combined, as may be the case) reached is measured, representing the response.

In embodiments, the step for determining the excitation frequency is performed separately for different modes of operation, in particular for modes of operation that cause opposite directions of movement.

This step for determining the excitation frequency corresponds to one mode of operation. Typically, it is repeated at least for several different modes of operation. Such different modes can correspond to movement in two opposite directions, linear or rotational. Different modes can be correspond to linear movements in different directions, in particular by exciting excitation means on opposite sides of the resonator with different amplitudes.

In embodiments, and considering two excitation frequencies corresponding to two modes of oscillation corresponding to movement of the drive in opposite directions, optimal excitation frequencies for the two are determined such that the response of the drive unit is the same in both directions.

This allows to balance the characteristics of the drive, which inherently are asymmetrical. to achieve the same performance regarding, for example, speed or displacement per driving pulse, in both directions.

In embodiments, for each one of one or more different modes of operation, the step for determining the excitation frequency is performed once, after the drive unit is assembled, and the optimal excitation frequency is stored in a controller of the drive unit and used in subsequent operation of the drive unit.

In embodiments, for each one of one or more different modes of operation, the step for determining the excitation frequency is performed repeatedly during the lifetime of the drive unit, and each time the optimal excitation frequency is stored in a controller of the drive unit and used in subsequent operation of the drive unit.

In embodiments, the method comprises the step of exciting excitation means on opposite sides of the resonator with different relations between the power of the excitation signals applied to the opposite excitation means, thereby driving the passive element relative to the active element in different directions, depending on said relations, these different directions being in a common plane and at an angle to one another, the angle being different from 0° and 180°.

In embodiments, the method comprises the step of exciting excitation means on opposite sides of the resonator with excitation signals that are phase shifted relative to one another, thereby driving the passive element relative to the active element in different directions, depending on the phase shift, these different directions being in a common plane and at an angle to one another, the angle being different from 0° and 180°.

A controller is configured to be connected to and power excitation means of a drive unit, and is configured to perform the method as described herein.

In embodiments, the drive unit is a piezoelectric drive unit, and the excitation means is a piezoelectric element. In other embodiments, the drive unit can use a electromagnetic actuator (such as a voice coil), magnetostrictive actuator or shape memory alloy based actuator.

Typically, the movement of the contact element serves to intermittently contact the passive element and to push it each time in a direction according to the movement of the contact element. A resulting direction of the movement passive element, depending on how it is supported, for example, to move linearly and/or to rotate, can be controlled by an excitation frequency of the excitation means, as explained in the applicant's prior WO 2006/000118 A1 or US 7'429'812 B2.

In embodiments, the resonator and its parts are manufactured of a single piece of sheet material, in particular, sheet metal.

In embodiments, the second arm is arranged to move with oscillating movements that balance the oscillating movement of the first arm.

That is, when the excitation means is excited with a frequency for driving the passive element relative to the active element, the first arm and second arm vibrate with movements that balance one another.

A resonator of the kind presented here typically has a resonator axis that corresponds to an axis of symmetry of the geometric shape of the resonator. For a resonator of generally planar shape, the resonator axis lies in its reference plane. The symmetry relative to the resonator axis is understood to correspond to the general shape of the arms, and may not be perfect with regard to details of the shape of the arms.

Thus, while the at least two arms extend in a substantially symmetric manner from the connection region, they can differ in details of their shape or contour. For example, one arm can be shorter than the other, measured in the direction in which the arms extend. For example, it can be up to 10% or up to 20% or up to 30% or up to 40% shorter than the other arm.

The arms being arranged symmetrically to one another, with regard to the resonator axis or to a point of symmetry, allows movements of the arms, when they oscillate, to balance each other. As a result, the oscillating movement of the resonator can be made essentially symmetric with respect to the resonator axis.

In embodiments, the passive element is arranged to move with a linear movement when driven by the first arm.

In embodiments, the passive element is arranged to move with a rotary movement when driven by the first arm.

In embodiments, the connection region is substantially of rectangular shape. The excitation means typically is substantially rectangular as well. Sides of a rectangle corresponding with a rectangular approximation of the connection region can be aligned in parallel with sides of a rectangle corresponding with a rectangular approximation of the excitation means.

The resonator and its parts being integrally shaped means, in other words, that the parts of the resonator, such as the connection region, first and second arms, attachment regions, and optionally a bearing arm are manufactured as a single part with the resonator. This can be done, for example, by stamping or cutting the resonator from a piece of sheet metal, or by casting, or by an additive manufacturing process.

Depending on the frequency, the active element can drive the passive element to move in a first direction, or in a second direction opposite to the first direction. In embodiments, the movement by the passive element is a translational movement. In others, it is a rotational movement.

Further embodiments are evident from the dependent patent claims. Features of the method claims may be combined with features of the device claims and vice versa.

The subject matter of the invention will be explained in more detail in the following text with reference to exemplary embodiments which are illustrated in the attached drawings, which schematically shows:

Figures 1 to 3     drive units for oscillating drives;
Figure 4           drive signals and resulting oscillation amplitudes when modulating a shape of driving pulses; and
Figure 5           drive signals and resulting oscillation amplitudes when modulating a presence of driving pulses.
Figure 6           a dependence of drive velocity v on pulse duty cycle dp;
Figure 7           a dependence of drive velocity v on excitation frequency f;
Figure 8           velocity trajectories over time, and steady state values for different excitation frequencies;
Figure 9           distance s covered for a fixed number of excitation pulses, for different excitation frequencies;
Figure 10          different modes of operation for asymmetric powering of two excitation means; and
Figure 11          a flow diagram for the method for operating a drive unit.

In principle, identical or functionally identical parts are provided with the same reference symbols in the figures.

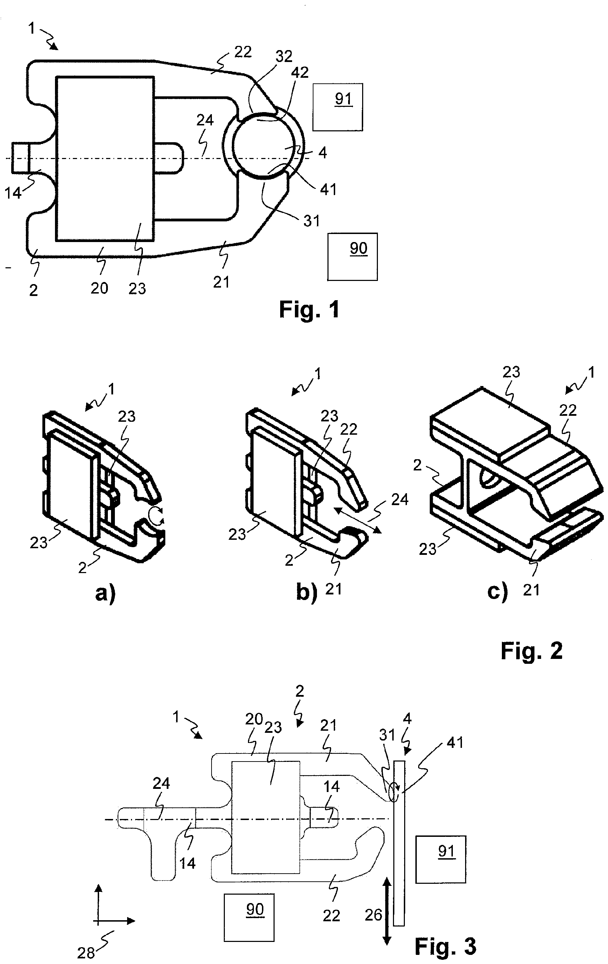

**Figure 1** shows a drive with an active element 1 comprising a resonator 2 with a pair of arms, a first arm 21 and a second arm 22, The arms 21, 22 and an attachment region 14 are attached to a connection region 20 of the resonator 2. The attachment region 14 serve to mount the resonator 2 to another part, such as a base element. An excitation means 23, for example, a piezoelectric element, is arranged on the connection region 20. A controller 90 is arranged to generate an excitation signal or excitation voltage for driving the excitation means 23. A position and/or speed and/or acceleration sensor 91 is arranged to measure a position and/or speed of the passive element 4 relative to the active element 1. The sensor 91 can be based on a measurement of a magnetic field that is influenced by the position of the passive element 4. The sensor 91 can be a Hall sensor, or can be a MEMS (Micro-Electro-Mechanical) device. The excitation means 23 can comprise two separate elements, arranged on opposing sides of the excitation means 23. The resonator 2 and the excitation means 23 are flat elements, stacked onto one another and extending in parallel to a reference plane reference plane 28 (see **Figure 3**). Upon excitation by an alternating voltage with an excitation frequency, the arms 21, 22 oscillate and, depending on the frequency, a first contact element 31 of the first arm 21 is made to perform a roughly linear movement. The linear oscillation can have an orthogonal component, so that the overall movement can be considered to be elliptical. Depending on the frequency, the direction of the linear oscillating (back and forth) movement can change. The first contact element 31 repeatedly contacts and drives a first contact area 41 of a passive element 4 relative to the active element 1. The same is the case for the second contact element 32 and the second contact area 42. Depending on the direction of the linear back and forth movement, the passive element is repeatedly pushed in a corresponding direction, and depending on how the passive element is suspended, it will perform, for example, a linear and/or a rotary movement. In the embodiment of **Figure 1**, the passive element 4 can rotate relative to the active element 1.

Given a certain geometry of the parts and the manner in which the passive element 4 is arranged to move relative to the active element 1, it is possible to determine, for a desired direction of movement (rotary or linear) an excitation frequency that for each oscillation, or for each pulse and resulting pushing motion, results in a maximal energy transfer for the desired movement. In order to reduce the energy transfer per pulse, the excitation frequency can be changed slightly so as to maintain the same general direction of the oscillating movement but to nevertheless change the direction slightly. This changes the angle of incidence at which the contact elements 31, 32 hit the respective contact areas 41, 42, as well as the amplitude of the oscillations, so that the energy transferred per pulse is reduced in comparison to the optimal angle. In this manner, a small relative change in excitation frequency can be used to control the speed at which the passive element 4 is moved.

A pre-stress force acts between the first contact element 31 and first contact area 41, and between the second contact element 32 and second contact area 42, respectively. The pre-stress force can be generated by an elasticity of the first arm 21 and second arm 22, the arms being forced apart when the passive element 4 is arranged between the contact elements 31, 32.

The first arm 21 and second arm 22 extend from the connection region 20 in a substantially symmetric manner, and can differ in details of their shape, in particular their contour, if they are manufactured from a flat piece of material. A resonator axis 24 corresponds to an axis of symmetry at which the resonator 2, in particular the connection region 20 and the arms 21, 22, can be mirrored, except for the abovementioned details of the arms. Movement of the connection region 20 and the arms 21, 22, when excited by the excitation means 23, can be generally symmetric, with the same axis of symmetry. Nodes of this movement, that is, regions of minimal movement, can be located on the resonator axis 24. Attachment regions 14 for mounting the active element 1 on another element, can also be located on the resonator axis 24.

**Figure 2** shows variations of active elements 1, with the passive elements 4 omitted for clarity. a) is an active element 1 as in **Figure 1.** In b), the active element 1 is suited for driving the passive element in a linear direction, in particular within the plane in which the two arms 21, 22 lie, as indicated by a double arrow, corresponding to a resonator axis 24. In a) and b), excitation means 23 are attached to opposite sides of the resonator 2. In c), the excitation means 23 are attached to separate surfaces to which the first and second arm 21, 22 are attached.

**Figure 3** shows a drive with essentially the same elements as the drive of Figure 1, also with a pair of arms, but only the first arm 21 is in contact with and driving the passive element 4. The movement of the passive element is along a linear movement axis 26.

In the embodiments presented so far the passive element 4 is arranged between the arms 21, 22, with the contact elements 31, 32 at the ends of the arms pointing inwards, towards one another. In other embodiments, not illustrated, the arms 21, 22, are shaped with the contact elements 31, 32 pointing outwards, away from one another. The passive element 4 is arranged to contact one or both of the contact elements 31, 32 from the outside.

Further embodiments of drives to which the method for driving presented herein can be applied are disclosed in the abovementioned WO 2006/000118 A1 or US 7'429'812 B2, and WO 2019/068708 A1 which are herewith incorporated in their entirety by reference.

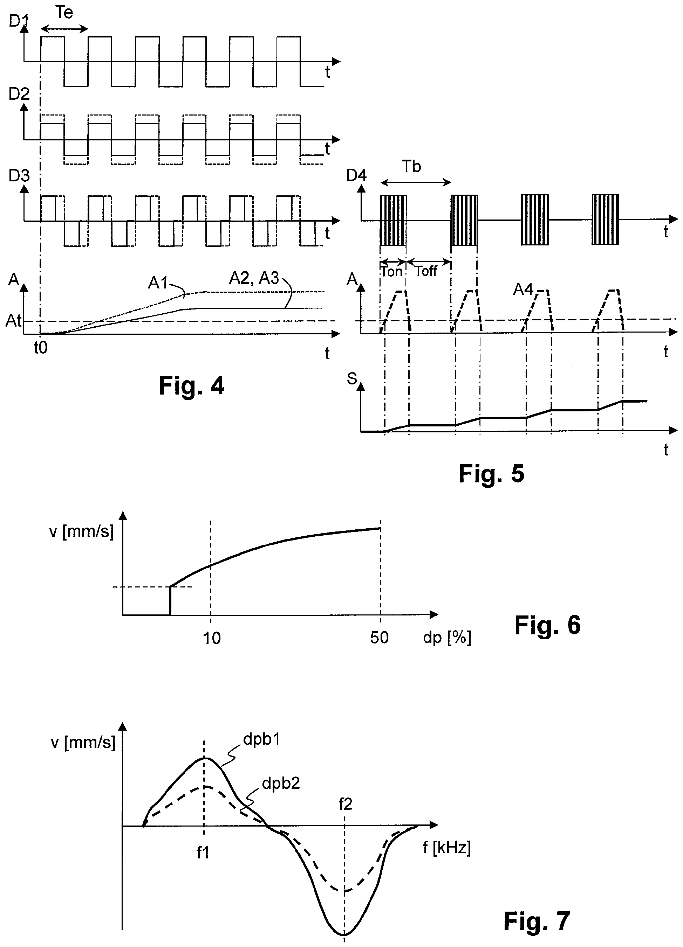

**Figure 4** shows, along the same time axis t, three driving signals D1, D2, D3 and corresponding amplitudes A1, A2, A3 **of oscillation by the active element** 1.

The first driving signal D1 is a rectangular signal with a period length Te, also called **pulse period**, corresponding to an excitation frequency fe = 1/Te, and with a maximal pulse width Te/2, that is, a duty cycle dp of 50%. Assuming that the pulse sequence of D1 begins at a start time t0, the corresponding first amplitude A1 of the oscillation rises, as subsequent pulses by means of the excitation means 23 transmit mechanical energy into the oscillation of the active element 1, in particular the resonator 2 and its arms. After a number of pulses, the oscillation reaches a maximum and then remains essentially constant, in a steady state condition. If the amplitude is below an activation threshold At, the arms do not impart a driving force to the passive element 4. If the amplitude is above the threshold, they do, and the passive element 4 is driven relative to the active element 1.

The second driving signal D2 results from amplitude modulation of the first driving signal D1, reducing the amplitude relative to its maximum. The third driving signal D3 results from pulse width modulation of the first driving signal D1, reducing its pulse width or pulse duty cycle relative to its maximum. For both the second and third driving signal D2, D3, the mechanical energy transmitted to the active element 1 per pulse is reduced relative to the first driving signal D1. Correspondingly, second and third amplitude trajectories A2, A3 rise slower than the first amplitude A1, and level off at lower constant or steady state values. The time required to exceed the activation threshold is longer than for the first driving signal D1.

The amplitude of oscillation by the active element corresponds to a speed at which the passive element 4 is moved relative to the active element 1. The speed of the drive unit can thus be controlled by controlling the energy imparted to the active element 1 per pulse, which in turn is a function of the shape of the pulse. The shape can be controlled by different types of modulation, for which pulse amplitude and/or pulse width modulation are well known examples.

Further reduction of the energy transmitted per pulse can give rise to the situation when the amplitude never exceeds the activation threshold At, or only occasionally in an unreliable manner. For this reason it is not possible to reduce the speed of the drive unit below a speed threshold. Generally, the speed threshold corresponds to the amplitude threshold. The speed threshold can be, depending on the physical and electrical properties of the drive unit, in the region of 20% to 40% of the maximal speed.

**Figure 6** illustrates the above in terms of the relation between pulse width or pulse duty cycle dp and the resulting velocity v: reducing the pulse duty cycle from 50%, which corresponds to maximal power, causes the velocity to decrease, down to a threshold at which it drops to zero.

In order to attain lower speeds, the shape of the driving signal is maintained such that the amplitude of the oscillation by the active element in the steady state is above the activation threshold by a safety margin. The drive is operated intermittently, as illustrated in **Figure 5.** This figure shows, along the same time axis t, a fourth driving signal D4, a corresponding amplitude A4 **of** oscillation by the active element 1, and a corresponding displacement S of the passive element 4 relative to the active element 1. The time axis is compressed when compared to that of Fig. 4. The fourth driving signal D4 comprises, during turn-on time Ton, pulses, and during turn-off time Toff, no pulses. Sequences with and without pulses can be periodically repeated with a **pulse block period** Tb, which can equal Ton + Toff. The pulse block period can also be designated **excitation period.** The corresponding frequency fb = 1/Tb with which pulse blocks are repeated shall be designated pulse block frequency. The relation of the turn-on time Ton to the pulse block period Tb, that is Ton/Tb, is designated **pulse block duty value** dpb. Its maximum, corresponding to maximal power, is 100%.

The drive is thus operated intermittently by applying pulses to the drive unit only during turn-on periods, and omitting or supressing pulses during turn-off periods. During the turn-on periods, which are sufficiently long for the amplitude to exceed the activation threshold, and after a corresponding delay, the passive element 4 is driven relative to the active element 1. During the turn-off periods, after a delay in which the oscillation decays, the pre-stress force causes the active element 1 to hold the passive element 4 in position. The displacement S increases by a repeated sequence of steps and stationary periods. The average slope of the displacement, as shown in Figure 5, represents the average speed of the passive element 4 relative to the active element 1.

In general, the speed refers the relative motion between active element 1 and passive element 4 seen along a linear axis. For a rotary drive, the angular speed corresponds to the speed divided by the radius at which the active element 1 drives the passive element 4.

For typical applications the pulse block period can correspond to a pulse block frequency fb=1/Tb between 5 kHz and 100 kHz, typically around 25 kHz. The pulses themselves can have a frequency between 50 kHz and 1000 kHz, typically around 500 kHz.

Resulting maximal speeds can be around 80 mm/sec. The step for each oscillation period can be in the range of 0.01 to 1 micrometres. Forces imparted by the active element 1 onto the passive element 4 can be up to 100 mN (that is, up to 0.1 N). Voltages applied to the excitation means 23 can be around 3 V.

In situations where a position of the drive unit needs to be attained, regardless of the speed, the controller can modify the position step size by which the position changes in one pulse period, for example,

- by modifying the shape of the driving pulses, thereby reducing the energy transferred per pulse, and thus the amplitude of the mechanical oscillation that drives the passive element;
- or by modifying the excitation frequency, thereby reducing the energy transfer to the mechanical oscillations and thus their amplitude, and/or thereby changing the direction of the mechanical oscillations and thus their contribution to a driving force that acts in the direction of movement of the passive element 4.

**Figure 7** illustrates the relation between the excitation frequency f and the resulting velocity v: at a first frequency f1, the resonator 2 is in a first mode of operation, or oscillation mode, and drives the passive element 4 with maximal speed in a first direction. At a second frequency f2, the resonator 2 is in a second mode of operation, and drives the passive element 4 with maximal speed in a second direction opposite to the first direction. For small deviations around f1 or f2, respectively, corresponding to a detuning of the excitation frequency relative to the natural frequency of the active element 1 in the respective oscillation mode, the respective speed decreases.

Since the speed reduction by detuning the excitation frequency can be attributed in part to the reduced energy transfer and in part to the reduced contribution of the movement of the first contact elements in the direction of movement, the reduced energy transfer can be compensated for by increasing the pulse duty cycle (assuming that it is not yet at its maximum). The net effect is that the amount of power that is converted into mechanical movement can be maintained at the same level as for the optimally tuned (not detuned) excitation, and the mechanical amplitude and force exerted by the contact elements on the passive element can also be maintained.

Given two mechanical frequencies and corresponding excitation frequencies f1 and f2 corresponding to two directions of movement, the problem arises to efficiently transfer electrical energy into the electromechanical system. This should be possible at both frequencies. The solution is to introduce a series inductance in series with a piezoelectric excitation means 23. As a first approximation, the piezoelectric excitation means 23 can be modelled as a capacitance Cp. Given the frequencies f1 and f2, the value L of the series inductance, according to corresponding embodiments, is chosen such that the oscillating frequency $f_R$ of the resonant circuit comprising L and Cp, which is (in Hertz)

$$f_R = \frac{1}{2\pi\sqrt{Cp\,L}}$$

lies between f1 and f2. In particular, the oscillating frequency $f_R$ can be placed at the middle frequency between f1 and f2. The series inductance L can be concentrated in one of the two connections through which the excitation means 23 is powered, or split over the two connections.

Alternatively, a parallel inductance can be used, with the oscillating frequency $f_R$ chosen in the same manner.

The above examples are explained in terms of a driving signal with rectangular pulses. The same principles, in particular regarding amplitude and pulse width modulation and the omission of pulses, can be applied with pulses of different shape. For example, with sinusoidal, triangular, trapezoidal or saw tooth pulses, or with pulses of arbitrary shape.

The optimal excitation frequencies f1 and f2 for opposite directions of movement, and perhaps further excitation frequencies for different modes and directions, generally depend on the individual mechanical and electrical properties of the drive unit, in particular of the resonator 2 and the excitation means 23. These properties can change over time, due to wear and parameter drift, depending on environmental conditions, such as temperature, moisture, and also depending on the orientation of the drive unit with regard to the direction of **gravity.** Correspondingly, the optimal values for excitation frequencies can change. In order to determine optimal values, the drive can be operated at different frequencies, measuring a target response, and determining the frequency at which the target response is optimal.

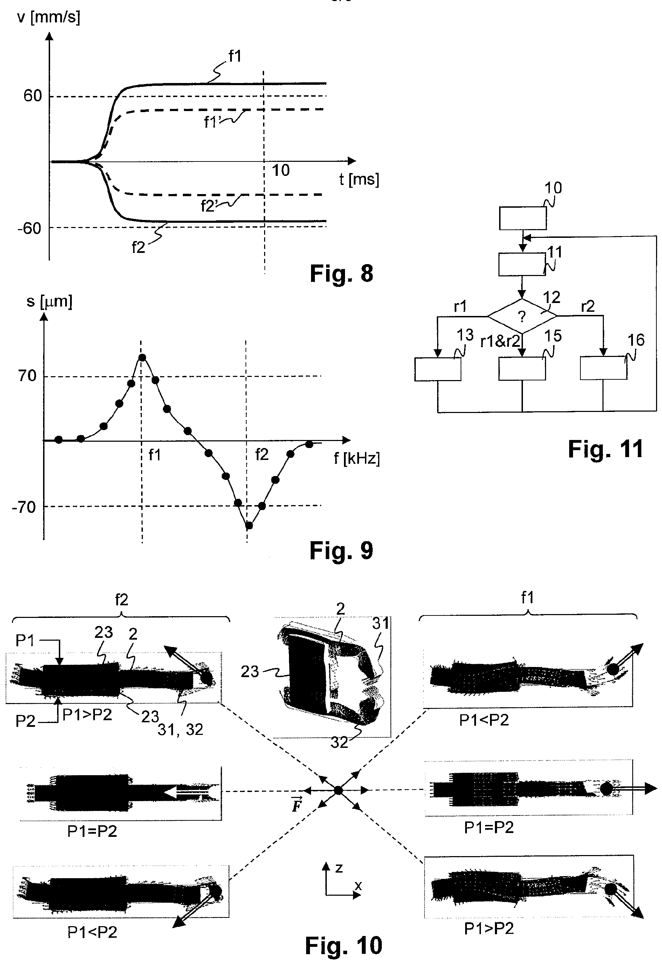

**Figure 8** illustrates this in a setting where a speed measurement is possible. Different curves show the evolution of drive speed over time, depending on the excitation frequency. At frequency f1, a maximum steady state speed in one direction is attained, at frequency f2 in the other direction. Non-optimal frequencies f1' and f2' deviating from f1 and f2, respectively, lead to lower steady state speeds. This way of determining the optimal excitation frequencies can be performed after assembly of the drive unit, in a calibration environment, with a speed measuring device which may not be available when the drive unit is incorporated in its destination environment.

**Figure 9** illustrates determining optimal frequencies based on position measurements alone: the drive unit is operated for a fixed number of steps or drive pulses, for example, 2000 drive pulses at various excitation frequencies. Then the change in position, denoted s, is measured. The frequencies with the largest displacement in the two opposing directions are chosen as optimal frequencies f1 and f2. This procedure can be performed during operation of the drive unit in its destination environment, mounted in a device. For example it can be performed at each start-up of the device, and/or at regular time intervals and/or when a change in conditions or performance of the drive unit is detected.

**Figure 10** illustrates different modes of operation attained by driving two excitation means 23 located at opposite sides of a resonator 2, with different relations between the power of the excitation signals applied to the two excitation means 23. The resonators correspond, for example, to those shown in Figure 1, 2a), 2b) and 3. In each case, the direction in which the passive element is pushed in the x-z-plane when the contact elements 31, 32 are in contact with the passive element is indicated by an arrow. The middle row shows the case in which the same excitation signal is applied to the two excitation means 23, with the two excitation frequencies f1 and f2, causing movement in opposing directions and within the plane of the resonators 2. The other rows show the effects of the power Pl, P2 of the signal driving one excitation means 23 being larger than the other. The power driving each excitation means 23 in turn can be modulated by the pulse duty cycle and/or the amplitude of pulses of the excitation signal.

The thickness of the resonator 2 determines the flexion mode that will be excited and thus it will determine to what extent an imbalance in the power Pl, P2 driving the two excitation means 23 affects the magnitude of movement of first and second contact elements 31, 32 in a direction outside of the resonator plane. Thus, the thickness can be chosen according to requirements on the direction of movement.

Similar modes of operation, and corresponding movement patterns, as in **Figure 10** can be obtained by phase shifting the excitation signals driving the excitation means 23 on opposite sides of the resonator 2. In particular, the phase shift can be 90°.

**Figure 11** shows a flow diagram for the method for operating the drive unit according to an embodiment. After an initialisation step 10, in a control step 11, the control signal is determined. In a branching step 12, depending on the value of the control signal, the method branches to one of the following steps:

- if the control signal is within a first range r1, then, in a first branch step 13, the shape and/or the frequency of the driving pulses is modified;
- if the control signal is within a second range r2, then, in a third branch step 16, driving pulses are repeatedly omitted;
- if the control signal is within both the first and the second range, then in a second branch step 15 the shape and/or the frequency of the driving pulses is modified, and driving pulses are repeatedly omitted.

The method then is iteratively repeated by continuing with the control step 11.

The control signal can be, for example, based on an error signal, the error signal being a deviation of the actual speed of the drive unit from a speed set point, or the error signal being a deviation of the actual position of the drive unit from a position set point.

Multiple strategies can be used to drive the motor. PID-based solutions can be used, as shown in the following representation of a time discrete controller:

$$error(n) = target(n) - feedback(n)$$

$$cmd(n) = P * error(n) + I * \sum_{i=0}^{n-1} error(i) + D * (error(n) - error(n-1))$$

Wherein *error(n)* denotes the value of the error signal in time step *n, target(n)* denotes a corresponding set point value and *feedback(n)* denotes the actual value. *cmd(n)* denotes an input value to drive unit, and *P, I, D* denote proportional, integral and derivative coefficients of a PID controller.

The input value to the drive unit can control the amplitude, and/or the shape and/or the frequency of the driving pulses, and/or the omission of driving pulses. The input value can be modified to compensate for non-linear characteristics of the drive unit's response.

Starting from the standard formula presented above, in embodiments, the following modifications can be implemented for driving the drive unit:

Depending on the range of the error between the target and the motor feedback, predefined settings are applied. For example:

▪

$$P(n) = \begin{pmatrix} error(n) > 100 & P(n) = 100/error(n) \\ 100 \geq error(n) > 10 & P(n) = 10/error(n) \\ 10 \geq error(n) & P(n) = 1/error(n) \end{pmatrix}$$

Such a segmentation approach can be sufficient for applications requiring low accuracy.

In embodiments for position control, group of different constant values defining controller speeds is used: A high speed value if the position error is larger than an upper threshold, a medium speed value for a medium position error range, and a low speed value if the position error is smaller than a lower threshold.

For applications requiring high positional accuracy and/or low settling time, a linear approach can be better than the segmental approach because of smoother transitions. This solution corresponds to a classical PID controller with fixed coefficients.

Depending on the application, individual limitations of P or I or D coefficients can be applied in order to limit their influence on the controller. For example:

▪

$$P * error(n) = \begin{pmatrix} P * error(n) > 70 & 70 \\ 70 \geq P * error(n) & P * error(n) \end{pmatrix}$$

In order to increase or decrease the influence of individual P or I or D parameters depending on the feedback error or derivative error or summation error, P or I or D value can be changed depending on the range area. This corresponds to a gain scheduling controller. For example:

■

$$P(n) = \begin{pmatrix} error(n) > 100 & P(n) = 100 \\ 100 \geq error(n) > 10 & P(n) = 10 \\ 10 \geq error(n) & P(n) = 1 \end{pmatrix}$$

Due to characteristics of the drive unit, the P-I-D coefficients can be varied depending on the error value. For example:

■

$$P(n) = P_2 * error(n)^2 + P_1 * error(n) + P_0$$

This solution can provide smoother transitions and may help in case of mechanical nonlinearities or feedback inaccuracies.

While the invention has been described in present embodiments, it is distinctly understood that the invention is not limited thereto, but may be otherwise variously embodied and practised within the scope of the claims.

**Claims**

1.  A method for operating a drive unit for driving a passive element (4) relative to an active element (1), wherein the active element (1) comprises

    a resonator (2) and at least one excitation means (23) for exciting oscillations in the resonator (2),
    the resonator (2) comprising at least one arm (21, 22) extending from a connection region (20) of the resonator (2),
    the at least one arm (21, 22) comprising, at an outer end of the arm, a contact element (31),
    the contact element (31) being movable by way of oscillating movements of the at least one arm (21),

    the passive element (4) being arranged to be driven and moved relative to the active element (1) by way of these oscillating movements;
    the passive element (4) comprising a first contact area (41), the first contact area (41) being arranged to be in contact with the first contact element (31);
    the active element 1 and passive element 4 being arranged for a pre-stress force to push, in particular when the active element (1) is not being excited, at least the first contact element (31) towards the first contact area (41);
    the method comprising the steps of

    • driving the excitation means (23) with a **driving signal**, the driving signal being a periodic signal comprising **driving pulses** repeated with an **excitation frequency;**
    • depending on a **control signal**, modifying the driving signal by:

        ◦ if the control signal is within a first range, modifying the excitation frequency or modifying the shape of the driving pulses while keeping the excitation frequency the same, while keeping an energy transmitted by each driving pulse above a nonzero **minimum pulse energy value,** in particular wherein the minimum pulse energy value is at least 5% of a maximum energy of a pulse; and
        ◦ if the control signal is within a second range, repeatedly omitting driving pulses.

2.  The method of claim 1, wherein the first and second range overlap.

**3.** The method of one of the preceding claims, wherein modifying the shape of the driving pulses is done by at least one of

• modifying the **amplitude** of the driving pulses depending on the control signal; and of
• modifying the **width** of the driving pulses depending on the control signal.

**4.** The method of one of the preceding claims, wherein keeping the energy transmitted by each driving pulse above the nonzero **minimum pulse energy value** is accomplished by keeping the pulse duty cycle of the driving pulses above a minimum pulse duty cycle value and by keeping the amplitude of the driving pulses above a minimum amplitude value.

**5.** The method of claim 4, wherein, the **minimum pulse energy value** is at least 5% or at least 10% of a maximum energy of a pulse.

**6.** The method of one of the preceding claims, wherein modifying the excitation frequency depending on the control signal comprises modifying the excitation frequency by an amount that does not alter the mode of oscillation but only reduces the matching between the excitation frequency and the natural frequency of the drive unit in this mode of oscillation.

**7.** The method of one of the preceding claims, wherein repeatedly omitting driving pulses, comprises modifying a duration of **turn-off periods** of time during which driving pulses are omitted depending on the control signal.

**8.** The method of one of the preceding claims, wherein, when repeatedly omitting driving pulses, during **turn-off periods** of time during which driving pulses are omitted, the pre-stress force holds the position of the passive element (4) relative to the active element (1).

**9.** The method of one of the preceding claims, wherein the excitation frequency is in the range between 50 kHz and 1000 kHz, and the repeated omission of driving pulses occurs with a frequency that is 10 to 100 times lower than the excitation frequency.

**10.** The method of one of the preceding claims, wherein the control signal corresponds to a speed set point, and the first range corresponds to higher speeds and the second range corresponds to lower speeds.

**11.** The method of one of the preceding claims, wherein the control signal corresponds to a position set point, and a position step size by which the position changes in one pulse period is controlled by modifying the shape of the driving pulses or the excitation frequency.

**12.** The method of one of the preceding claims, comprising, for actively reducing the speed of the drive unit, the steps of

• driving the excitation means (23) with a first **driving signal** having a first excitation frequency driving the drive in a first direction;
• reducing the speed by driving the excitation means (23) with a second **driving signal** having a second excitation frequency driving the drive in a second direction opposite to the first direction.

**13.** The method of claims 12, wherein reducing the speed of the drive is accomplished by reducing the duty cycle and/or the amplitude of the driving pulses while keeping the excitation frequency the same, or by detuning the excitation frequency from the natural frequency of the drive unit while essentially maintaining its mode of oscillation.

**14.** The method of one of the preceding claims, wherein reducing the speed of the drive is accomplished by omitting driving pulses and by braking the drive by means of the pre-stress force.

**15.** The method of one of the preceding claims, comprising, for controlling the movement of the drive unit by switching between at least two excitation frequencies, the repeated execution of the steps of.

• for a first number of pulses, driving the excitation means (23) with a first **driving signal** having a first excitation frequency;
• for a second number of pulses, driving the excitation means (23) with a second **driving signal** having a second excitation frequency.

**16.** The method of one of the preceding claims, comprising the step of determining the excitation frequency depending on a desired oscillation mode of the resonator (2), in particular depending on a desired direction of relative movement of the passive element (4) relative to the active element (1), by the steps of

- repeatedly driving the active element (1) with different excitation frequencies and measuring, for each excitation frequency, an associated response of the drive unit, in particular the response being a speed of movement or a displacement of the passive element (4) relative to the active element (1);
- selecting, for future operation of the drive unit, an optimal excitation frequency that optimises the response, in particular maximises the response.

**17.** The method of claim 16, wherein for each of the different excitation frequencies being evaluated, a certain number of drive pulses is applied to the active element, and the resulting linear or rotational or combined displacement is measured, representing the response.

**18.** The method of claim 16, wherein for each of the different excitation frequencies being evaluated, drive pulses are applied to the active element, and the steady state speed reached is measured, representing the response.

**19.** The method of one of claims 16 to 18, wherein the step for determining the excitation frequency is performed separately for different modes of operation, in particular for modes of operation that cause opposite directions of movement.

**20.** The method of one of claims 16 to 19, wherein for two excitation frequencies corresponding to two modes of oscillation corresponding to movement of the drive in opposite directions, optimal excitation frequencies for the two are determined such that the response of the drive unit is the same in both directions.

**21.** The method of one of claims 16 to 20, wherein, for each one of one or more different modes of operation, the step for determining the excitation frequency is performed once, after the drive unit is assembled, and the optimal excitation frequency is stored in a controller (90) of the drive unit and used in subsequent operation of the drive unit.

**22.** The method of one of claims 16 to 21, wherein, for each one of one or more different modes of operation, the step for determining the excitation frequency is performed repeatedly during the lifetime of the drive unit, and each time the optimal excitation frequency is stored in a controller (90) of the drive unit and used in subsequent operation of the drive unit.

**23.** The method of one of the preceding claims, comprising the step of exciting excitation means (23) on opposite sides of the resonator (2) with different relations between the power of the excitation signals applied to the opposite excitation means (23), thereby driving the passive element (4) relative to the active element (1) in different directions, depending on said relations, these different directions being in a common plane and at an angle to one another, the angle being different from 0° and 180°.

**24.** The method of one of the preceding claims, comprising the step of exciting excitation means (23) on opposite sides of the resonator (2) with excitation signals that are phase shifted relative to one another, thereby driving the passive element (4) relative to the active element (1) in different directions, depending on the phase shift, these different directions being in a common plane and at an angle to one another, the angle being different from 0° and 180°.

**25.** A controller (90), configured to be connected to and power excitation means (23) of a drive unit, the controller being configured to perform the method according to one of the preceding claims.

**Fig. 1**

a)    b)    c)

**Fig. 2**

**Fig. 3**

**Fig. 4**

**Fig. 5**

**Fig. 6**

**Fig. 7**

**Fig. 8**

**Fig. 9**

**Fig. 11**

**Fig. 10**

Europäisches
Patentamt

European
Patent Office

Office européen
des brevets

## EUROPEAN SEARCH REPORT

Application Number

EP 19 21 6018

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 952 834 A (OKADA JUNJI [JP]) 28 August 1990 (1990-08-28) * column 3 - column 4; claim 11; figures 2,4 * | 1-15 | INV. H03B5/32 H03K3/66 |
| A | US 6 768 245 B2 (CREAHOLIC SA [CH]) 27 July 2004 (2004-07-27) * column 10, line 6 - column 11, line 53; claim 1; figure 8 * | 1-15 | |
| A | US 5 170 087 A (KARR BARRETT [US] ET AL) 8 December 1992 (1992-12-08) * figure 1 * | 1-15 | |

TECHNICAL FIELDS
SEARCHED      (IPC)

H03B
H03D
H03K

The present search report has been drawn up for all claims

| Place of search | Date of completion of the search | Examiner |
|---|---|---|
| Munich | 3 November 2020 | Riccio, Ettore |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 19 21 6018

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2020

| Patent document cited in search report | | Publication date | Patent family member(s) | | Publication date |
|---|---|---|---|---|---|
| US 4952834 | A | 28-08-1990 | JP | H01234073 A | 19-09-1989 |
| | | | US | 4952834 A | 28-08-1990 |
| US 6768245 | B2 | 27-07-2004 | AT | 370519 T | 15-09-2007 |
| | | | AU | 1377801 A | 12-06-2001 |
| | | | EP | 1234346 A1 | 28-08-2002 |
| | | | JP | 4795596 B2 | 19-10-2011 |
| | | | JP | 2003516100 A | 07-05-2003 |
| | | | US | 2003052575 A1 | 20-03-2003 |
| | | | WO | 0141228 A1 | 07-06-2001 |
| US 5170087 | A | 08-12-1992 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006000118 A1
- US 7429812 B2

- WO 2019068708 A1